(19) Europäisches Patentamt
European Patent Office
Office européen des brevets

(11) **EP 1 763 135 B1**

(12) **EUROPÄISCHE PATENTSCHRIFT**

(45) Veröffentlichungstag und Bekanntmachung des Hinweises auf die Patenterteilung:
**02.12.2015   Patentblatt 2015/49**

(51) Int Cl.:
***H03H 17/04*** *(2006.01)*      ***H03H 17/06*** *(2006.01)*
***H03H 17/02*** *(2006.01)*

(21) Anmeldenummer: **06018465.2**

(22) Anmeldetag: **04.09.2006**

(54) **Dezimierende Filterkaskade mit minimierter Einschwingzeit nach Reinitialisierung**

Decimating filter cascade with minimized settling time after reinitialization

Cascade de filtres à décimation à temps de stabilisation après réinitialisation réduit au minimum

(84) Benannte Vertragsstaaten:
**DE FR GB**

(30) Priorität: **09.09.2005   DE 102005043010**

(43) Veröffentlichungstag der Anmeldung:
**14.03.2007   Patentblatt 2007/11**

(73) Patentinhaber: **Rohde & Schwarz GmbH & Co. KG**
**81671 München (DE)**

(72) Erfinder:
• **Reinhold, Michael**
**81929 München (DE)**
• **Huber, Johann**
**85570 Markt Schwaben (DE)**

(74) Vertreter: **Körfer, Thomas et al**
**Mitscherlich PartmbB**
**Patent- und Rechtsanwälte**
**Postfach 33 06 09**
**80066 München (DE)**

(56) Entgegenhaltungen:
**EP-A2- 0 285 317     EP-A2- 0 427 377**

• **S. CHU ; C. S. BURRUS: "Optimum FIR and IIR Multistage Multirate Filter Design" CIRCUITS, SYSTEMS, AND SIGNAL PROCESSING, Bd. 2, Nr. 3, 1983, Seiten 361-386, XP002409259 USA**
• **CROCHIERE R E ET AL: "Multirate Digital Signal Processing, MULTISTAGE IMPLEMENTATIONS OF SAMPLING RATE CONVERSION" MULTIRATE DIGITAL SIGNAL PROCESSING, ENGLEWOOD CLIFFS, PRENTICE-HALL INC, US, 1983, Seiten 193-196, XP002271059**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine dezimierende Filterkaskade mit minimierter Einschwingzeit nach Reinitialisierung.

In der digitalen Signalverarbeitung gibt es zahlreiche Anwendungen, in denen die Abtastfrequenz des abgetasteten Signals verringert werden muss. Hierzu werden dezimierende Filter eingesetzt, die sich in Transversal- und Polyphasenfilter unterteilen.

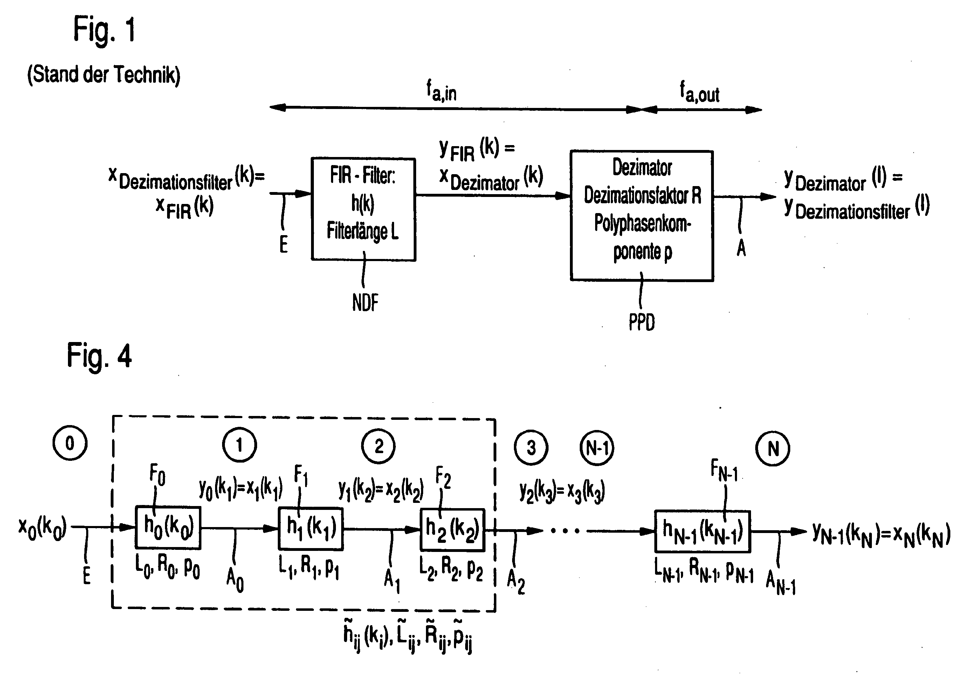

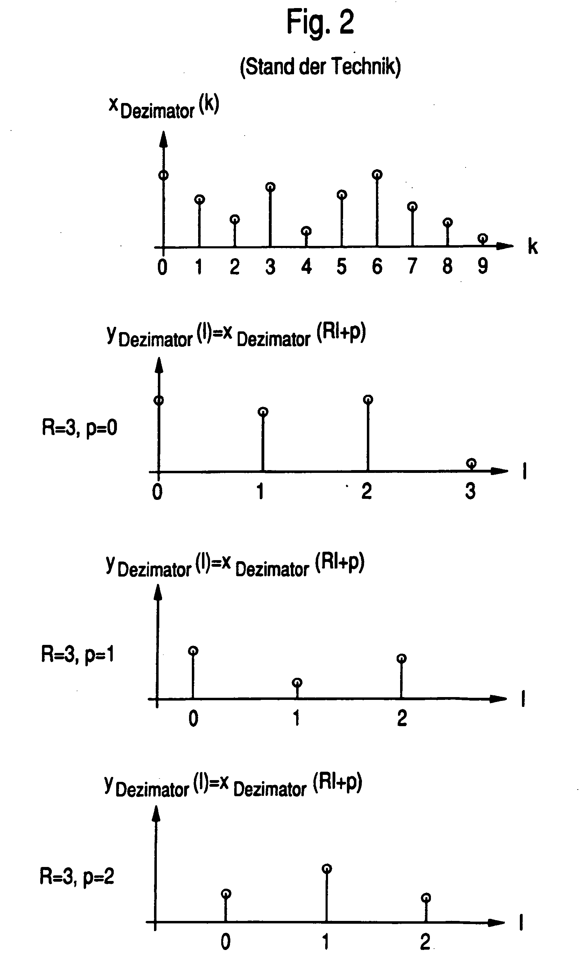

Reale Polyphasenfilter, die im folgenden betrachtet werden, können durch ein Ersatzschaltbild mit einer Serienschaltung aus einem nicht dezimierenden Filter NDF und einem idealen Polyphasendezimator PPD beschrieben werden. Gemäß Fig. 1 ist das nicht dezimierende Filter NDF beispielsweise als Finite-Impulse-Response-Filter (FIR-Filter) mit einer Übertragungsfunktion h(k) und einer Filterlänge L realisiert. Alternativ kann für das nicht dezimierende Filter auch ein Infinite-Impulse-Response-Filter (IIR-Filter) oder ein Cascaded-Integrator-Comb-Filter (CIC-Filter) eingesetzt werden. Der dazu in Serie geschaltete ideale Polyphasendezimator PPD führt eine Reduzierung der Abtastfrequenz $f_{a,in}$ seines Eingangssignals um einen Dezimationsfaktor $R = \dfrac{f_{a,in}}{f_{a,out}}$ in eine Abtastfrequenz $f_{a,out}$ seines Ausgangssignals durch. Über die Polyphasenkomponente p wird vom idealen Polyphasendezimator PPD der Phasenversatz des Ausgangssignals gegenüber dem Eingangssignal in Anzahl von Abtastzeitpunkten eingestellt. Fig. 2 zeigt für ein gegebenes Eingangssignal $x_{Dezimator}(k)$ das von einem idealen Polyphasendezimator PPD erzeugte abtastratenreduzierte Ausgangssignal $y_{DEZIMATOR}(l)$ für einen Dezimationsfaktor R=3 und eine Polyphasenkomponente von p=0, p=1 und p=2.

Die Filterung des abgetasteten Eingangssignals in einem FIR-Filter NDF bewirkt, daß das resultierende Ausgangssignal aufgrund der Faltung des abgetasteten Eingangssignals mit der Impulsantwort h(k) des FIR-Filters NDF erst nach einer bestimmten Anzahl von Abtastzeitpunkten einen "korrekten Wert" aufweist und somit eingeschwungen ist. Dieser Einschwingvorgang ist nach insgesamt L-1 Abtastzeitpunkten abgeschlossen, wobei L die Filterlänge des FIR-Filters NDF ist. Durch die Kombination des FIR-Filters NDF mit dem idealen Polyphasendezimator PPD ergibt sich, wie weiter unten noch im Detail gezeigt wird, eine weitere Verschlechterung des Einschwingvorgangs.

In der Spektrumanalyse kann nach einer Abwärtsmischung von der Zwischenfrequenz ins Basisband, einer Empfangsfilterung und einer starken Abtastratenreduzierung die minimale Bandbreite des sogenannten VIDEO-Filters abhängig von der Messung beispielsweise 1 Hz betragen, so daß die Abtastrate des Signals am Ausgang der Filterkaskade entsprechend niedrig ist. Insbesondere bei derart niedrigen Abtastraten des Signals am Ausgang der Filterkaskade kann die Messzeit durch eine optimale Wahl der Polyphasenkomponente verkürzt werden.

Hinzukommt, daß in vielen Messanwendungen wie beispielsweise in der Spektrumsanalyse sogenannte gegatete Messungen durchgeführt werden, in denen mehrere Signalabschnitte mit gültigen Meßwerten von Signalabschnitten mit ungültigen Meßwerten unterbrochen sind. Jeder neue Signalabschnitt, in dem gültige Meßwerte vorliegen, stellt für die dezimierende Filterkaskade eine neue Anregung dar, die zu einem neuen Einschwingvorgang der dezimierenden Filterkaskade führt. Im Gegensatz zum ersten gültigen Signalabschnitt, in denen die dezimierende Filterkaskade vorab keine Anregung durch ungültige Meßwerte erfährt, wird die dezimierende Filterkaskade in allen nachfolgenden gültigen Signalabschnitten vorab mit ungültigen Meßwerten fälschlicherweise angeregt und zum Zeitpunkt des Einsetzens des gültigen Signalabschnitts in einen Filterzustand überführt, der nicht dem originären Filterzustand zu Beginn des ersten gültigen Signalabschnitts entspricht und deshalb zu einer weiteren Verschlechterung der Einschwingzeit der dezimierenden Filterkaskade führen kann.

EP 0 285 317 offenbart eine Filterkaskade, die mehrere dezimierende FIR-Filterstufen aufweist. Die Erstellung der Ausgangssequenzen in jeder Filterstufe ist unterdrückt bis die Filterstufe das erste Element der Datensequenz empfängt, das gleichphasig mit dem ersten Element der Eingangsdatensequenz der vorangehenden Filterstufe ist. Somit wird die Phase der Ausgangssequenz der Filterkaskade mit der Phase der Eingangssequenz synchronisiert.

Aufgabe der Erfindung ist es deshalb, die Einschwingzeit einer dezimierenden Filterkaskade, insbesondere auch für den Anwendungsfall von gegateten Messungen, zu minimieren.

Die Aufgabe wird durch die Merkmale des Anspruchs 1 gelöst. Die abhängigen Ansprüche enthalten vorteilhafte Weiterbildungen der Erfindung.

Als Bedingung für eine minimierte Einschwingzeit des dezimierenden Filters beziehungsweise der dezimierenden Filterkaskade wird die Einschwingzeit eines FIR-Filters NDF herangezogen, die einer Anzahl von Abtastzeitpunkten des Ausgangssignals in Höhe der um 1 reduzierten Filterlänge L entspricht.

Handelt es sich um ein einziges dezimierendes Filter, so ergibt sich erfindungsgemäß die Polyphasenkomponente p des idealen Polyphasendezimators PPD für eine minimale Einschwingzeit des dezimierenden Filters als Rest der Modulo-Division der um 1 reduzierten Filterlänge L durch den Dezimationsfaktor R. Bei einer derartigen Belegung der Polyphasenkomponente p kommt genau ein Abtastwert des Ausgangssignals des dezimierenden Filters auf denjenigen Abtastzeitpunkt des Eingangssignals des dezimierenden Filters zu liegen, der um insgesamt L-1 Abtastzeitpunkte vom Beginn der Anregung des dezimierenden Filters entfernt liegt und damit zum frühestmöglichen Zeitpunkt eingeschwungen ist.

Liegt eine dezimierende Filterkaskade vor, so ergeben sich erfindungsgemäß die Polyphasenkomponenten der einzelnen Polyphasendezimatoren PPD der dezimierenden Filterkaskade aus der Betrachtung, dass jeweils genau ein Abtastwert aller Abtastwerte des am Ausgang des jeweiligen Polyphasendezimators PPD anliegenden Ausgangssignals auf denjenigen Abtastzeitpunkt des Eingangssignals der dezimierenden Filterkaskade zu liegen kommt, der um eine Anzahl von Abtastzeitpunkten vom Beginn der Anregung der dezimierenden Filterkaskade entfernt liegt, die genau der um 1 reduzierten Filterlänge $\tilde{L}$ der gesamten dezimierenden Filterkaskade entspricht. Bei einer derartigen Festlegung der Polyphasenkomponente aller Polyphasendezimatoren PPD der dezimierende Filterkaskade sind erfindungsgemäß sämtliche Ausgangssignale der in der dezimierenden Filterkaskade seriell verschalteten dezimierenden Filter frühestmöglich eingeschwungen.

Neben einer rein seriellen Anordnung der einzelnen dezimierenden Filter in einer dezimierenden Filterkaskade gibt es auch Anwendungen von dezimierenden Filterkaskaden, in denen die einzelnen dezimierenden Filter sowohl seriell wie auch parallel zueinander angeordnet sind. Aufgrund der seriellen und parallelen Verschaltung der einzelnen dezimierenden Filter sind mehrere Eingänge $E_1$, $E_2$,... und Ausgänge $A_1$, $A_2$,... vorhanden und damit mehrere Filterpfade zwischen jeweils einem Eingang und einem Ausgang in einer derartigen dezimierenden Filterkaskade ausgebildet. Um ein minimales Einschwingen jedes Filterpfades der dezimierenden Filterkaskade zu verwirklichen, müssen die einzelnen Polyphasenkomponenten p der einzelnen dezimierenden Filter des jeweiligen Filterpfades analog wie im Fall einer rein seriellen Verschaltung der einzelnen dezimierenden Filter in einer dezimierenden Filterkaskade ausgelegt werden.

Liegt ein Eingangssignal der dezimierenden Filterkaskade vor, das mehrere Signalabschnitte mit gültigen Abtastwerten aufweist, die durch jeweils einen Signalabschnitt mit ungültigen Abtastwerten voneinander getrennt sind, werden die einzelnen dezimierenden Filter der dezimierenden Filterkaskade bei Beginn jedes gültigen Signalabschnitts reinitialisiert. Die Reinitialisierung der dezimierenden Filter bewirkt ein Rücksetzen sämtlicher Verzögerungsstufen der als nicht dezimierender Filteranteil verwendeten FIR-, IIR- oder CIC-Filter und der als dezimierender Filteranteil verwendeten Polyphasendezimatoren.

Die Reinitialisierung der einzelnen dezimierenden Filter kann jeweils über ein Steuersignal erfolgen, das zentral von einer übergeordneten Einheit zur Ablaufsteuerung erzeugt wird oder von dem im jeweiligen Filterpfad vorgelagerten dezimierenden Filter nach dessen Reinitialisierung weitergereicht wird.

Nach der Reinitialisierung der einzelnen dezimierenden Filter der dezimierenden Filterkaskade sind die Polyphasenkomponenten der einzelnen Polyphasendezimatoren äquivalent wie bei einem Eingangssignal, das nur gültige Abtastwerte enthält, zu dimensionieren, um ein Einschwingen der dezimierenden Filterkaskade in minimaler Zeit zu gewährleisten.

Ausführungsbeispiele der erfindungsgemäßen dezimierenden Filterkaskade werden im folgenden unter Berücksichtigung der Zeichnung näher erläutert. In der Zeichnung zeigen:

Fig. 1    ein Ersatzschaltbild für ein dezimierendes Filter,

Fig. 2    eine Zeitdiagramm des Eingangs- und Ausgangssignals eines idealen Polyphasendezimators für verschiedene Polyphasenkomponenten p,

Fig. 3    ein Zeitdiagramm des Eingangs-, Zwischenund Ausgangssignals eines dezimierenden Filters nach dem Stand der Technik und eines erfindungsgemäßen dezimierenden Filters ohne Reinitialisierung,

Fig. 4    ein Ersatzschaltbild einer ersten Ausführungsform einer dezimierenden Filterkaskade ohne Reinitialisierung,

Fig. 5    ein Zeitdiagramm des Eingangs-, Zwischenund Ausgangssignal einer erfindungsgemäßen dezimierenden Filterkaskade ohne Reinitialisierung,

Fig. 6    ein Ersatzschaltbild einer zweiten Ausführungsform einer dezimierenden Filterkaskade ohne Reinitialisierung,

Fig. 7    ein Zeitdiagramm eines gegateten Eingangssignals, des korrespondierenden FIR-Filter-Ausgangssignals und des korrespondierenden Polyphasendezimator-Ausgangssignals des erfindungsgemäßen dezimierenden Filters ohne Reinitialisierung und mit Reinitialisierung,

Fig. 8    ein Zeitdiagramm eines gegateten Eingangssignals des korrespondierenden ersten Polyphasen- und des zweiten Polyphasen-Ausgangssignals der erfindungsgemäßen dezimierenden Filterkaskade mit Reinitialisierung,

Fig. 9    ein Blockschaltbild einer ersten Ausführungsform einer erfindungsgemäßen dezimierenden Filterkaskade mit Reinitialisierung und

Fig. 10   ein Blockschaltbild einer zweiten Ausführungsform einer erfindungsgemäßen Filterkaskade mit Reinitialisierung.

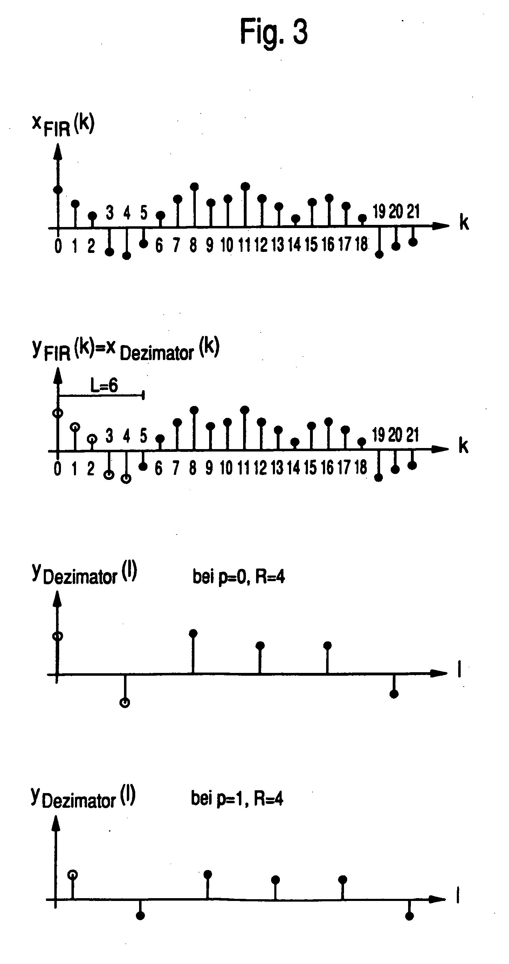

Anhand der Zeitdiagramme von Fig. 3 werden im folgenden die Zusammenhänge für die Auslegung eines erfindungsgemäßen dezimierenden Filters mit minimaler Einschwingzeit ohne Reinitialisierung erläutert.

Das dezimierende Filter wird gemäß Fig. 1 und Fig. 3, Zeile 1, an seinem Eingang E mit einem abgetasteten Eingangssignal $x_{Dezimationsfilter}(k)$ beaufschlagt, das zugleich das Eingangssignal $x_{FIR}(k)$ des nicht dezimierenden FIR-Filters NDF ist. Das FIR-Filter NDF weist eine Filterlänge L von 6 auf, so daß das abgetastete Ausgangssignal $y_{FIR}(k)$, das gleichzeitig das abgetastete Eingangssignal $x_{Dezimator}(k)$ des idealen Polyphasendezimators PPD ist, nach insgesamt L-1=5 Abtastzeitpunkten seit Anregung des FIR-Filters NDF mit dem abgetasteten Eingangssignal $x_{FIR}(k)$ eingeschwungen ist. Der eingeschwungene Zustand des abgetasteten Ausgangssignals $y_{FIR}(k)$ des FIR-Filters NDF für Abtastzeitpunkte $k \geq L - 1 = 5$ wird in Fig. 3, Zeile 2, durch einen ausgefüllten Abtastwert gekennzeichnet, während die noch nicht eingeschwungenen Abtastwerte $y_{FIR}(k)$ des Ausgangssignals des FIR-Filters NDF für Abtastzeiten $k < L - 1 = 5$ durch einen nicht-ausgefüllten Abtastwert dargestellt werden.

Das Ausgangssignal $y_{Dezimator}(l)$ des idealen Polyphasendezimators PPD, dessen Laufindex $l$ die reduzierte Abtastrate $f_{a,out}$ anzeigt, ist gleichzeitig auch das Ausgangssignal $y_{Dezimationsfilter}(l)$ des dezimierenden Filters. Der ideale Polyphasendezimator PPD generiert aus seinem abgetasteten Eingangssignal $x_{Dezimator}(l)$ entsprechend Gleichung (1) mittels der einstellbaren Polyphasenkomponente p und des einstellbaren Dezimationsfaktors R ein abtastratenreduziertes Ausgangssignal $y_{Dezimatar}(l)$.

$$y_{Dezimator}(l) = x_{Dezimator}(l \cdot R + p) \qquad\qquad (1)$$

Die Einstellung des Dezimationsfaktors R ergibt, wie weiter oben schon dargestellt, die Höhe der Abtastratenreduzierung zwischen der Abtastrate $f_{a,in}$ des Eingangssignals $x_{Dezimator}(l)$ und der Abtastrate $f_{a,out}$ des Ausgangssignals $y_{Dezimator}(l)$.

Die Einstellung der Polyphasenkomponente p, die entsprechend der Bedingung in Gleichung (2) erfolgt, bestimmt, zu welchem Zeitpunkt das abgetastete Ausgangssignal $y_{Dezimator}(l)$ relativ zum abgetasteten Eingangssignal $x_{Dezimator}(l)$ erzeugt wird:

$$0 \leq p \leq R - 1 \qquad\qquad (2)$$

Der $l$-te Abtastwert des Ausgangssignals $y_{Dezimator}(l)$ erscheint bei gegebenen Dezimationsfaktor R und gegebener Polyphasenkomponente p zum gemäß Gleichung (3) berechneten Abtastzeitpunkt k am Ausgang des idealen Polyphasendezimators PPD.

$$k = l \cdot R + p \qquad\qquad (3)$$

Wird für einen nicht-optimierten Einschwingvorgang des dezimierenden Filters der Dezimationsfaktor $R = 4$ und die Polyphasenkomponente $p = 0$ gewählt, so erscheint der erste eingeschwungene Wert des abgetasteten Ausgangssignals $y_{Dezimator}(l)$ des idealen Polyphasendezimators PPD zum Zeitpunkt $k=8$ (Fig. 3, Zeile 3). Bei optimaler Wahl der Polyphasenkomponente $p = 1$ erhält man bereits bei $k = 5$ am Ausgang des idealen Polyphasendezimators PPD einen eingeschwungenen Ausgangswert (Fig. 3, Zeile 4). Dies entspricht der durch die Filterlänge $L = 6$ des FIR-Filters NDF festgelegten minimalen Einschwingzeit des FIR-Filters NDF.

Als Optimalitätskriterium muß folglich ausgehend von Gleichung (3) die Bedingung in Gleichung (4) erfüllt sein.

$$k = L - 1 = l \cdot R + p \qquad\qquad (4)$$

Dieses Optimalitätskriterium für minimiertes Einschwingverhalten eines dezimierenden Filters impliziert die in Gleichung (5) dargestellte Berechnungsvorschrift für die Polyphasenkomponente $P$ :

$$p = \mathrm{MOD}\{L-1, R\} \qquad (5)$$

Somit erhält man zum frühest möglichen Zeitpunkt $k = L - 1$ einen eingeschwungenen Ausgangswert am Ausgang A des dezimierenden Filters. Bei einem IIR- oder CIC-Filter verwendet man in Gleichung (3) anstelle der Filterlänge L die entsprechende systemtheoretische Ersatzfilterlänge $L_{IIR}$ bzw. $\tilde{L}_{CIC}$.

Ausgehend von Gleichung (2) beträgt der Zeitgewinn $\Delta t$ bei optimaler Wahl der Polyphasenkomponente $P$ im Vergleich zur ungünstigsten Wahl der Polyphasenkomponente $P$ gemäß Gleichung (6):

$$\Delta t = \frac{R-1}{f_{a,in}} \qquad (6)$$

Besteht die Signalverarbeitungskette nicht nur aus einem einzigen dezimierenden Filter, sondern gemäß der ersten Ausführungsform der Erfindung aus mehreren in Reihe geschalteten dezimierenden Filtern, so muß die in Gleichung (5) dargestellte Einstellungsvorschrift für die Polyphasenkomponente p des idealen Polyphasendezimators PPD für die optimale Einstellung der Polyphasenkomponente $p_i$ der einzelnen Polyphasendezimatoren PPD$_i$ der Filterkaskade erweitert werden, wie im folgenden hergeleitet wird.

Gemäß Fig. 4 besteht die dezimierende Filterkaskade aus insgesamt N dezimierenden Filtern F$_0$, F$_1$, F$_2$,...,F$_{N-1}$, welche jeweils - ohne die in Fig. 1 dargestellte gedankliche Trennung in ein nicht dezimierendes FIR-Filter NDF und einen idealen Polyphasendezimator PPD - eine Übertragungsfunktion $h_i(k_i)$, eine Filterlänge $L_i$, einen Dezimationsfaktor $R_i$ und eine Polyphasenkomponente $p_i$ aufweisen. Das dezimierende Filter F$_i$ erzeugt ein Ausgangssignal $y_i(k_i)$, dessen Index $k_i$ zur Abtastrate $f_{a,i}$ korrespondiert, aus einem Eingangssignal $x_i(k_j)$, dessen Index $k_j$ zur gegenüber der Abtastrate $f_{a,i}$ höheren Abtastrate $f_{a,j}$ korrespondiert. Für ein nicht dezimierendes Filter NDF gilt in dieser Schreibweise $R_i = 1$ und $p_i = 0$.

Die dezimierenden Filter F$_i$,...,F$_{j-1}$ zwischen den Ebenen *i* und j - in Fig. 4 sei *i*=0 und *j*=3 gewählt - können durch ein dezimierendes Ersatzfilter mit der Übertragungsfunktion $\tilde{h}_{ij}(k_i)$, der Filterlänge $\tilde{L}_{ij}$, dem Dezimationsfaktor $\tilde{R}_{ij}$ sowie der Polyphasenkomponente $\tilde{p}_{ij}$ ersetzt werden. Die Ersatzgrößen $\tilde{h}_{ij}(k_i)$, $\tilde{L}_{ij}$, $\tilde{R}_{ij}$ und $\tilde{p}_{ij}$ berechnen sich wie folgt:

Für den Dezimationsfaktor $\tilde{R}_{ij}$ des dezimierenden Ersatzfilters gilt die Berechnungsvorschrift in Gleichung (7), wobei $R_\xi$ der Dezimationsfaktor des dezimierenden Filters F$_\xi$ ist:

$$\tilde{R}_{ij} = \prod_{\xi=i}^{j-1} R_\xi \quad \mathrm{mit} \quad \tilde{R}_{ii} = 1 \qquad (7)$$

Für die Polyphasenkomponente $\tilde{p}_{ij}$ des dezimierenden Ersatzfilters gilt die Berechnungsvorschrift in Gleichung (8), wobei $p_\xi$ die Polyphasenkomponente des dezimierenden Filters F$_\xi$ ist:

$$\tilde{p}_{ij} = \sum_{\xi=i}^{j-1} \tilde{R}_{i\xi} p_\xi \quad \mathrm{mit} \quad \tilde{p}_{ii} = 0 \qquad (8)$$

Um die Ersatzübertragungsfunktion $\tilde{h}_{ij}(k_i)$ zu berechnen, müssen zunächst die einzelnen Übertragungsfunktionen $h_\xi(k_\xi)$ des jeweiligen dezimierenden Filters F$_\xi$ zwischen den Abtastebenen $i<\xi<j$ von der Ebene $\xi$ mit der Abtastfrequenz $f_{a,\xi}$ in die Ebene *i* mit der Abtastfrequenz $f_{a,i}$ transformiert werden. Eine auf die Ebene *i* mit der Abtastfrequenz $f_{a,i}$ transformierte Übertragungsfunktion wird im folgenden mit $\tilde{h}_\xi(k_i)$ bezeichnet und hat gemäß Gleichung (9) die Eigenschaft:

$$\tilde{h}_\xi(k_i) = \begin{cases} h_\xi(k_\xi) & \mathrm{für} \; k_i = \tilde{R}_{i\xi} \cdot k_\xi \\ 0 & \mathrm{sonst} \end{cases} \qquad (9)$$

Die transformierte Übertragungsfunktion $\tilde{h}_\xi(k_i)$ des dezimierenden Filters F$_\xi$ ergibt sich aus der ursprünglichen Übertragungsfunktion $h_\xi(k_\xi)$ des dezimierenden Filters F$_\xi$, indem die transformierte Übertragungsfunktion $\tilde{h}_\xi(k_i)$ zwischen den einzelnen Abtastzeitpunkten $k_i = \tilde{R}_{i\xi} k_\xi$ jeweils mit insgesamt $\tilde{R}_{i\xi}-1$ Nullen ergänzt wird.

Somit ergibt sich gemäß Gleichung (10) die Übertragungsfunktion $\tilde{h}_{ij}(k_i)$ des dezimierenden Ersatzfilters zwischen den Abtastebenen i und j aus einer Faltung der auf die Abtastregion *i* transformierten Übertragungsfunktionen

$\tilde{h}_\xi(k_i)$ der einzelnen dezimierenden Filter $F_\xi$ zwischen den Abtastebenen $i<\xi<j$:

$$\tilde{h}_{ij} = h_i(k_i) * \tilde{h}_{i+1}(k_i) * \ldots * \tilde{h}_{j-2}(k_{j-2}) * \tilde{h}_{j-1}(k_{j-1}) \qquad (10)$$

Die Länge $\tilde{L}_{ij}$ des Ersatzfilters ergibt sich gemäß Gleichung (11) aus der Filterlänge $L_\xi$ des dezimierenden Filters $F_\xi$ und des Dezimationsfaktors $R_{i\xi}$ des dezimierenden Ersatzfilters zwischen der Abtastebene i und $\xi$:

$$\tilde{L}_{ij} = 1 + \sum_{\xi=1}^{j-1} \tilde{R}_{i\xi} \cdot (L_\xi - 1) \qquad (11)$$

Der zeitliche Zusammenhang zwischen der Abtastregion i und der Abtastregion j lautet in Anlehnung an Gleichung (3) gemäß Gleichung (12):

$$k_i = k_j \cdot \tilde{R}_{ij} + \tilde{p}_{ij} \qquad (12)$$

Analog zur minimalen Einschwingzeit eines einzelnen dezimierenden Filters $F_\xi$ in Höhe der um 1 reduzierten Filterlänge L des FIR-Filters NDF ergibt sich die minimale Einschwingzeit einer dezimierende Filterkaskade mit mehreren dezimierenden Filtern $F_i,\ldots,F_{j-1}$ zwischen den Abtastebenen i und j aus der um 1 reduzierten Filterlänge $\tilde{L}_{ij}$ des Ersatzfilters zwischen den Abtastebenen i und j. Folglich muß gemäß Gleichung (13) unter Berücksichtigung von Gleichung (11) zum Abtastzeitpunkt $k_i$ ein Abtastwert am Ausgang $A_i,\ldots,A_{j-1}$ der dezimierenden Filterkaskade $F_i,\ldots,F_{j-1}$ vorliegen, um ein minimales Einschwingen der dezimierenden Filterkaskade zu erzielen.

$$k_i = \tilde{L}_{ij} - 1 = \sum_{\xi=1}^{j-1} R_{i\xi} \cdot (L_\xi - 1) \qquad (13)$$

Der Zeitgewinn $\Delta t$ bei optimaler Wahl der Polyphasenkomponenten einer dezimierenden Filterkaskade im Vergleich zur ungünstigsten Wahl der Polyphasenkomponenten einer dezimierenden Filterkaskade beträgt gemäß Gleichung (14):

$$\Delta t = \frac{R_{ij} - 1}{f_{a,i}} \qquad (14)$$

Analog zum Optimalitätskriterium für minimiertes Einschwingverhalten eines dezimierenden Filters in Gleichung (5), muß für jedes dezimierende Filter $F_\xi$ einer dezimierenden Filterkaskade zwischen den Abtastebenen i und j ein in der Abtastebene $F_\xi$ zum Abtastzeitpunkt $k_\xi$ am Ausgang des dezimierenden Filters $F_\xi$ anliegender Abtastwert $y_{\xi-1}(k_\xi)$ des Ausgangssignals $y_\xi$ - 1 zum Abtastzeitpunkt $k_i = \tilde{L}_{ij}$ - 1 in der Abtastebene i zu liegen kommen. Ausgehend von Gleichung (12) muß in Analogie zu Gleichung (12) für den Fall eines einzigen dezimierenden Filters das Optimalitätskriterium in Gleichung (15) erfüllt sein.

$$k_i = \tilde{L}_{ij} - 1 = k_\xi \cdot \tilde{R}_{i\xi} + \tilde{p}_{i\xi} \qquad \forall i < \xi \leq j \qquad (15)$$

Dieses Optimalitätskriterium für minimiertes Einschwingverhalten einer dezimierenden Filterkaskade impliziert, daß der Abtastzeitpunkt $k_\xi$ des am Ausgang jedes dezimierenden Filters $F_\xi$ anliegenden Abtastwertes $y_{\xi-1}(k_\xi)$ des Ausgangssignals $y_{\xi-1}$ ganzzahlig sein muß und somit Gleichung (16) erfüllen muß:

$$\text{MOD} \left\{ k_i - \tilde{p}_{i\xi}, \tilde{R}_{i\xi} \right\} = 0 \qquad \forall i < \xi \leq j \qquad (16)$$

Das Optimalitätskriterium in Gleichung (16) kann folgendermaßen umgeformt werden:
Hierzu wird Gleichung (8) mathematisch umgeformt nach Gleichung (17):

$$\tilde{p}_{ij} = \tilde{R}_{i,j-1}p_{j-1} + \sum_{\xi=i}^{j-2}\tilde{R}_{i\xi}p_{\xi} = \tilde{R}_{i,j-1}p_{j-1} + \tilde{p}_{i,j-1} \quad \text{mit} \quad \tilde{p}_{ii} = 0 \qquad (17)$$

Wendet man die Erkenntnis aus Gleichung (17) im Optimalitätskriterium der Gleichung (16) an, so ergibt sich Gleichung (18):

$$\text{MOD}\left\{k_i - \tilde{p}_{i,\xi-1} - \tilde{R}_{i,\xi-1}p_{\xi-1}, \tilde{R}_{i\xi}\right\} = 0 \qquad \forall i < \xi \leq j \qquad (18)$$

Zur Vereinfachung wird Gleichung (18) in eine äquivalente Form gemäß Gleichung (19) umgeschrieben:

$$\text{MOD}\{A - bC, R\} = 0 \quad \text{mit} \quad A = k_i - \tilde{p}_{i,\xi-1}; \quad b = \tilde{R}_{i,\xi-1}; \quad C = p_{\xi-1}; \quad R = \tilde{R}_{i\xi} \qquad (19)$$

Gleichung (19) kann unter Einführung eines ganzzahligen Faktors $\lambda$ nach Gleichung (20) bzw. nach Gleichung (21) übergeführt werden:

$$A - bC - \lambda R = 0 \qquad (20)$$

$$C = \frac{1}{b}(A - \lambda R) \qquad (21)$$

Die rechte Seite von Gleichung (21) lässt sich wiederum als Modulo-Bedingung gemäß Gleichung (22) beschreiben:

$$C = \frac{1}{b} \cdot \text{MOD}\{A, R\} \qquad (22)$$

Führt man in Gleichung (22) eine Resubstitution der Hilfsgrößen A, b, C und R aus Gleichung (19) durch, so erhält man Gleichung (23):

$$p_{\xi-1} = \frac{1}{\tilde{R}_{i,\xi-1}} \cdot \text{MOD}\left\{k_i - \tilde{p}_{i,\xi-1}, \tilde{R}_{i\xi}\right\} \qquad \forall i < \xi \leq j \qquad (23)$$

Nach Substitution von $\mu = \xi - 1$ in Gleichung (23) erhält man Gleichung (24):

$$p_{\mu} = \frac{1}{\tilde{R}_{i,\mu}} \cdot \text{MOD}\left\{k_i - \tilde{p}_{i,\mu}, \tilde{R}_{i,\mu+1}\right\} \qquad \forall i \leq \mu < j \qquad (24)$$

Mit Hilfe von Gleichung (24) lassen sich die einzelnen Polyphasenfaktoren $p_{\mu}$ der einzelnen dezimierenden Filter $F_{\mu}$ der dezimierenden Filterkaskade iterativ beginnend mit $\mu = i$ berechnen.
Eine dezimierende Filterkaskade aus beispielsweise drei dezimierenden Filtern sei gegeben. Zum Zeitpunkt $k_0 = \tilde{L}_{03} - 1$ soll eine dezimierende Filterkaskade eingeschwungen sein. Die einzelnen Polyphasenkomponenten $p_0, ..., p_2$ der drei dezimierenden Filter lassen sich gemäß Gleichung (24a), (24b) und (24c) bestimmen:

$$p_0 = \frac{1}{\tilde{R}_{00}} \cdot \text{MOD}\left\{k_0 - \tilde{p}_{00}, \tilde{R}_{01}\right\} = \text{MOD}\{k_0, R_0\} \qquad (24a)$$

$$p_1 = \frac{1}{\tilde{R}_{01}} \cdot \mathrm{MOD}\{k_0 - \tilde{p}_{01}, \tilde{R}_{02}\} = \frac{1}{R_0} \cdot \mathrm{MOD}\{k_0 - p_0, R_0 R_1\} \qquad (24b)$$

$$p_2 = \frac{1}{\tilde{R}_{02}} \cdot \mathrm{MOD}\{k_0 - \tilde{p}_{02}, \tilde{R}_{03}\} = \frac{1}{R_0 R_1} \cdot \mathrm{MOD}\{k_0 - p_0 - p_1 R_0, R_0 R_1 R_2\} \quad (24c)$$

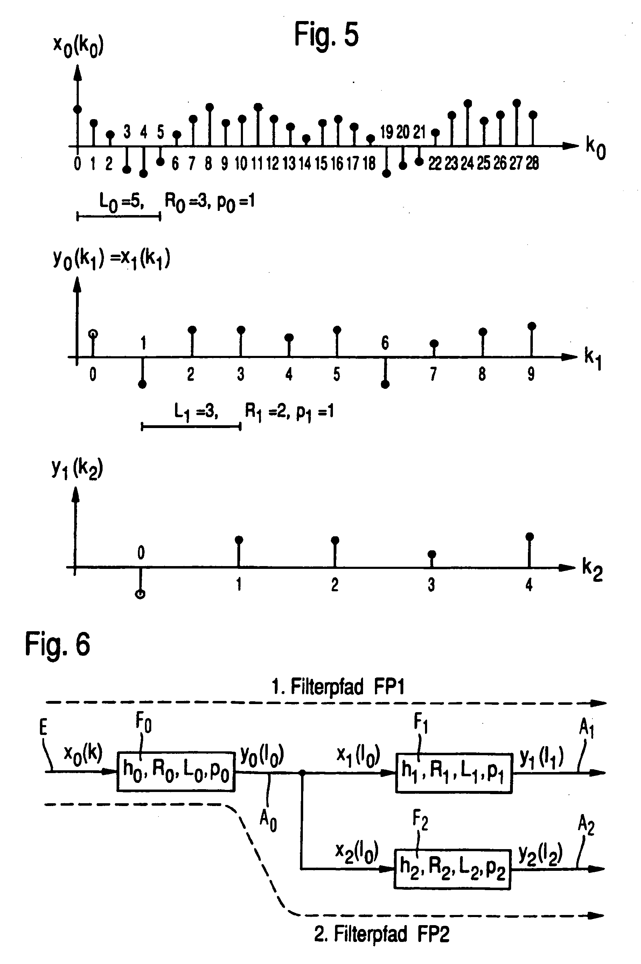

Das Zeitdiagramm in Fig. 5 zeigt für eine erste Ausführungsform einer dezimierenden Filterkaskade aus zwei seriell verschalteten dezimierenden Filtern in Zeile 1 ein abgetastetes Eingangssignal $x_0(k_0)$, in Zeile 2 das abgetastete Ausgangssignal $y_0(k_1)$ am Ausgang des ersten dezimierenden Filters und in Zeile 3 das abgetastete Ausgangssignal $y_1(k_2)$ am Ausgang des zweiten dezimierenden Filters.

In Fig. 5 ist zu erkennen, daß in Zeile 2 mit der Wahl der Polyphasenkomponente $p_0$ des ersten dezimierenden Filters $F_0$ ($p_0 = 1$) gemäß Gleichung (24a) ($p_0 = \mathrm{MOD}\{k_0 = L_0 - 1, R_0\} = \mathrm{MOD}\{4,3\}$) ein zeitoptimales Einschwingen des ersten dezimierenden Filters $F_0$ zum Abtastzeitpunkt $k_0 = L_0 - 1 = 4$ erzielt wird. Aus Zeile 3 der Fig. 5 ist außerdem zu erkennen, daß mit der Wahl der Polyphasenkomponente $p_1$ des zweiten dezimierenden Filters $F_1$ ($p_1 = 1$) gemäß Gleichung (24b) $p_1 = \frac{1}{R_0} \cdot \mathrm{MOD}\{k_0 - p_0, R_0 R_1\} = \frac{1}{3} \cdot \mathrm{MOD}\{4-1, 3\cdot 2\}$ ebenfalls ein zeitoptimales Einschwingen des zweiten dezimierenden Filters $F_1$ zum Abtastzeitpunkt $k_0 = \tilde{L}_{02} - 1 = 10$ gemäß Gleichung (12) bei einer Filterlänge $\tilde{L}_{02} = 11$ der dezimierenden Filterkaskade gemäß Gleichung (11) erreicht wird.

Bei einer zweiten Ausführungsform einer erfindungsgemäßen Filterkaskade gemäß Fig. 6 sind die einzelnen dezimierenden Filter nicht nur seriell, sondern auch parallel geschaltet. Beispielsweise bildet sich in der dezimierenden Filterkaskade der Fig. 6 auf diese Weise zwischen dem Eingang E und einem ersten Ausgang $A_1$ der dezimierenden Filterkaskade ein erster Filterpfad $FP_1$ mit dem dezimierenden Filter $F_0$ und dem dazu seriell verschalteten dezimierenden Filter $F_1$ und ein zweiter Filterpfad $FP_2$ mit dem dezimierenden Filter $F_0$ und dem dezimierenden Filter $F_2$.

Für die Bestimmung optimierter Polyphasenkomponenten in den einzelnen dezimierenden Filtern $F_0, F_1, F_2$ sind die einzelnen Filterpfade $FP_1, FP_2$ als serielle Verschaltung mehrerer dezimierender Filter $F_0, F_1, F_2$ zu betrachten und in analoger Weise wie in der ersten Ausführungsform einer erfindungsgemäßen dezimierenden Filterkaskade vorzugehen. Auf diese Weise kann insbesondere sicher gestellt werden, dass zu gleichen Zeitpunkten in beiden Filterpfaden $FP_1, FP_2$ Ausgangssignale erzeugt werden.

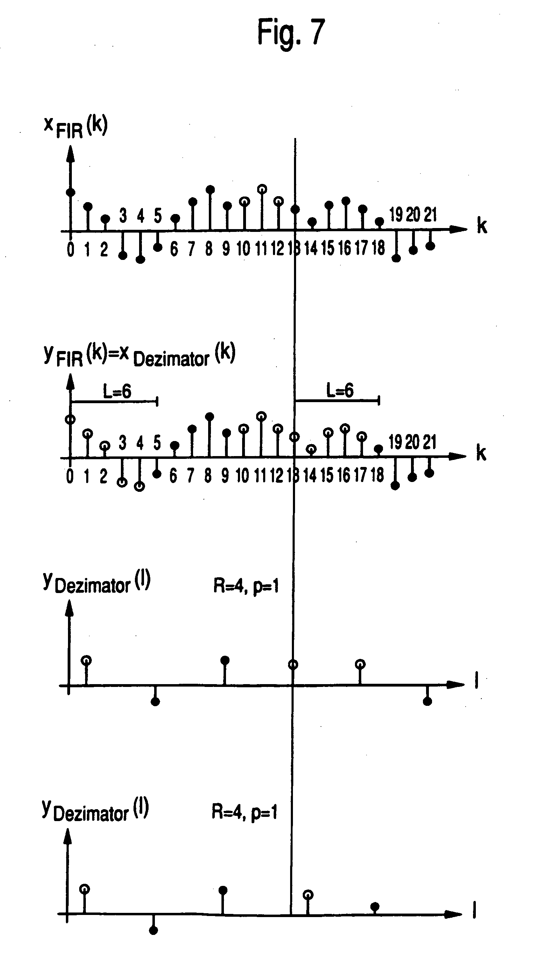

Wird ein einzelnes dezimierendes Filter entsprechend Fig. 1 mit einem abgetasteten Eingangssignal $x_{\mathrm{Dezimationsfilter}}(k) = x_{\mathrm{FIR}}(k)$ gemäß Fig. 7, 1. Zeile, beaufschlagt, das aus Signalabschnitten mit gültigen Abtastwerten - ausgefüllte Abtastwerte in Fig. 7 - und dazwischenliegenden Signalabschnitten mit ungültigen Abtastwerten - unausgefüllte Abtastwerte in Fig. 7 - besteht, so liegen aufgrund der Faltung des Eingangssignals $x_{\mathrm{Dezimationsfilter}}(k) = x_{\mathrm{FIR}}(k)$ mit der Impulsantwort $h(k)$ des nicht dezimierenden Filters NDF, das gemäß Fig. 1 als FIR-Filter realisiert ist, am Ausgang des FIR-Filters erst nach insgesamt L-1 Abtastzeitpunkten ab Beginn eines gültigen Signalabschnitts des Eingangssignals $x_{\mathrm{Dezimationsfilter}}(k) = x_{\mathrm{FIR}}(k)$ gültige Abtastwerte des Ausgangssignals $y_{\mathrm{FIR}}(k) = x_{\mathrm{Dezimator}}(k)$ vor. Da die Filterlänge L beim FIR-Filter der Fig. 7 den Wert 6 aufweist und der erste gültige Signalabschnitt beim Abtastzeitpunkt k=0 sowie der zweite gültige Signalabschnitt beim Abtastzeitpunkt k=13 beginnt, liegen am Ausgang des FIR-Filters gemäß Fig. 7, 2. Zeile, erst zum Zeitpunkt k=5 bzw. zum Abtastzeitpunkt k=18 gültige Abtastwerte des Ausgangssignals $y_{\mathrm{FIR}}(k) = x_{\mathrm{Dezimator}}(k)$ vor.

Das abgetastete Signal $y_{\mathrm{Dezimator}}(l)$ am Ausgang A des Polyphasendezimators PPD weist bei einem Dezimationsfaktor R=4 und einer Polyphasenkomponente p=1 bei fehlender Reinitialisierung des FIR-Filters den in Fig. 7, 3. Zeile, dargestellten Verlauf auf. Zu erkennen ist, daß im ersten gültigen Signalabschnitt des Eingangssignals $x_{\mathrm{Dezimationsfilter}}(k) = x_{\mathrm{FIR}}(k)$ das abgetastete Ausgangssignal $y_{\mathrm{Dezimator}}(1)$ des dezimierenden Filters zum Abtastzeitpunkt k=5 bei minimaler Einschwingzeit gültige Abtastwerte aufweist, während im zweiten gültigen Signalabschnitt des Eingangssignals $x_{\mathrm{Dezimationsfilter}}(k) = x_{\mathrm{FIR}}(k)$ das abgetastete Ausgangssignal $y_{\mathrm{Dezimator}}(l)$ des dezimierenden Filters erst zum Abtastzeitpunkt k=21 und nicht zum frühestmöglichen Abtastzeitpunkt k=18 gültige Abtastwerte anliegen. Dieses verschlechterte Einschwingen des dezimierenden Filters im zweiten Signalabschnitt resultiert aus dem obig in der Einleitung beschriebenen nicht originären Filterzustand des nicht dezimierenden FIR-Filters und des Polyphasendezimators zum Zeitpunkt k=13 des Beginns des zweiten gültigen Signalabschnitts.

Wird dagegen das dezimierende Filter - nicht dezimierendes FIR-Filter und Polyphasendezimator - zu Beginn jedes Signalabschnitts, das gültige Abtastwerte des Eingangssignals $x_{\mathrm{Dezimationsfilter}}(k) = x_{\mathrm{FIR}}(k)$ aufweist, erfindungsgemäß zurückgesetzt, so erfolgt mit der optimal eingestellten Polyphasenkomponente p des Polyphasendezimators PPD ein Einschwingen des dezimierenden Filters in minimaler Zeit. Ein Zurücksetzen - Reinitialisierung - des dezimierenden Filters zu Beginn des ersten Signalabschnitts ist nicht erforderlich, da sich zu diesem Zeitpunkt das dezimierende Filter in seinem originären Filterzustand befindet.

In der 4. Zeile der Fig. 7 ist das optimale Einschwingen des abgetasteten Ausgangssignals $y_{Dezimator}(l)$ des dezimierenden Filters im zweiten gültigen Signalabschnitt bei Reinitialisierung des dezimierenden Filters zum Abtastzeitpunkt k=13 des Beginns des zweiten gültigen Signalabschnitts zu erkennen: Bei minimaler Einschwingzeit ist das dezimierende Filter frühestmöglich zum Abtastzeitpunkt k=18 an seinem Ausgang A eingeschwungen.

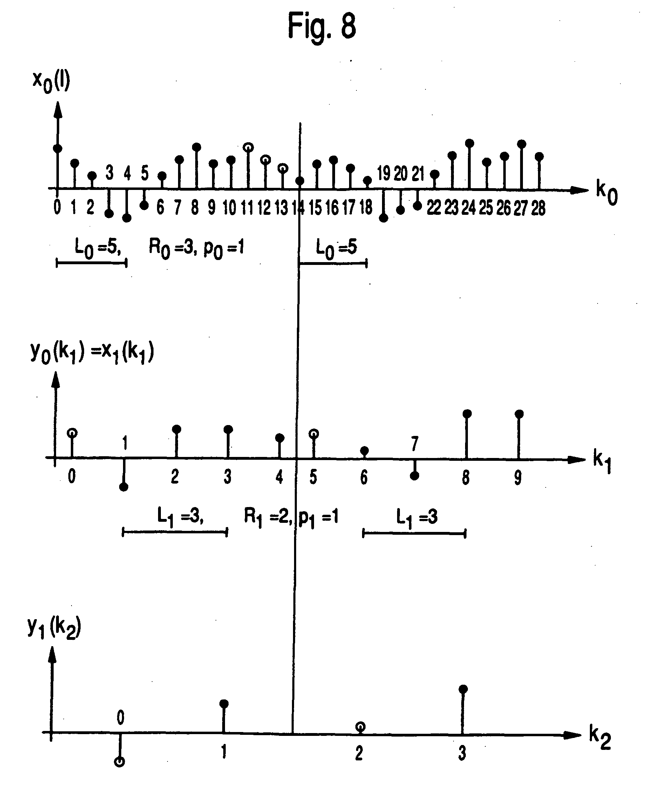

Im Zeitdiagramm der Fig. 8 ist das Einschwingen einer erfindungsgemäßen dezimierenden Filterkaskade mit zwei seriell verschalteten dezimierenden Filtern bei einem abgetasteten Eingangssignal $x_{Dezimationsfilter}(k) = x_{FIR}(k)$ mit einem Beginn eines gültigen Signalabschnitts zum Abtastzeitpunkt k=0 und k=14 (Fig. 8, 1. Zeile) gezeigt. Das erste dezimierende Filter mit einer Filterlänge $L_0=5$ schwingt bei einem Dezimationsfaktor $R_0=3$ und einer optimierten Poly-phasenkomponente $p_0=1$ im ersten gültigen Signalabschnitt zum frühestmöglichen Abtastzeitpunkt $k=L_0-1=4$ und im zweiten gültigen Signalabschnitt bei einer Reinitialisierung des dezimierenden Filters zum Zeitpunkt k=14 des Beginns des zweiten gültigen Signalabschnitts zum frühest möglichen Abtastzeitpunkt $k=14+L_0-1=18$ ein (Fig. 8, 2. Zeile). Analog schwingt das zweite dezimierende Filter mit einer Filterlänge $L_1=3$ bei einem Dezimationsfaktor $R_1=2$ und einer opti-mierten Polyphasenkomponente $p_1=1$ im ersten gültigen Signalabschnitt zum frühestmöglichen Abtastzeitpunkt $k=\tilde{L}_{02}-1=10$ mit einer Ersatzfilterlänge $\tilde{L}_{02}=11$ der dezimierenden Filterkaskade und im zweiten gültigen Signalabschnitt bei einer Reinitialisierung des dezimierenden Filters zum Zeitpunkt k=14 des Beginns des zweiten gültigen Signalabschnitts zum frühestmöglichen Abtastzeitpunkt $k=14+\tilde{L}_{02}-1=24$ ein (Fig. 8, 3. Zeile). Der zeitliche Abstand zwischen dem letzten und nächsten Abtastwert kann durch die Reinitialisierung unverändert bleiben, aber er kann sich auch verkürzen (2 Abtastzeitpunkte $k_0$ im Signal $y_0(k_1)$ der Zeile 2 der Fig. 8) oder verlängern (8 Abtastzeitpunkte $k_0$ im Signal $y_1(k_2)$ der Zeile 3 der Fig. 8).

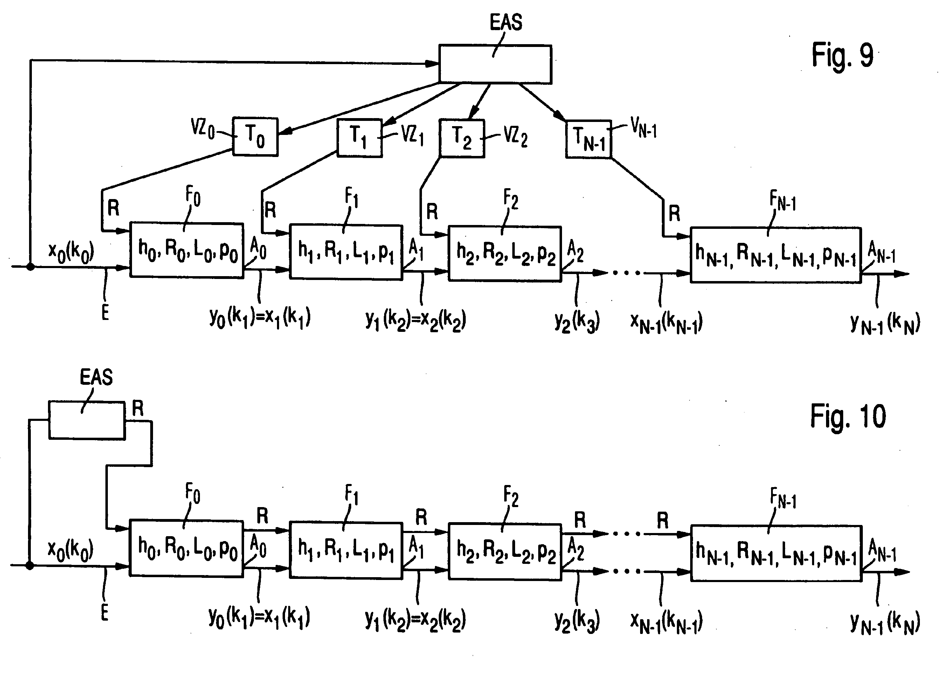

Die Reinitialisierung der einzelnen dezimierenden Filter einer erfindungsgemäßen dezimierenden Filterkaskade erfolgt in einer ersten Ausführungsform der erfindungsgemäßen Filterkaskade mit Reinitialisierung in Fig. 9 zentral über eine Einheit zur übergeordneten Ablaufsteuerung EAS, die ausgehend vom abgetasteten Eingangssignal $x_{Dezimationsfilter}(k) = x_{FIR}(k)$ der dezimierenden Filterkaskade für jedes dezimierende Filter $F_0$, $F_1$, $F_2$, ... , $F_{N-1}$ ein Reinitialisierungssignal R zum Rücksetzen sämtlicher Verzögerungsstufen des jeweiligen nicht dezimierenden FIR-Filters und des Polyphasendezimators jedes dezimierenden Filters $F_0$, $F_1$, $F_2$, ... , $F_{N-1}$ generiert. Das jeweilige Reinitialisierungssignal R wird durch ein im jeweiligen Pfad von der Einheit zur übergeordneten Ablaufsteuerung EAS zum jeweiligen dezimierenden Filter $F_0,F_1,F_2,...,F_{N-1}$ integriertes Verzögerungsglied $VZ_0/VZ_1,VZ_2,...,VZ_{N-1}$ jeweils mit einer spezifischen Verzögerungszeit $T_0,T_1,T_2,...,T_{N-1}$ verzögert.

Diese spezifische Verzögerungszeit $T_0,T_1,T_2,...,T_{N-1}$ berücksichtigt die unterschiedliche Hardware bedingte Laufzeit des zu filternden Meßsignals vom Eingang der Filterkaskade zum Eingang des jeweiligen Filters $F_0,F_1,F_2,...,F_{N-1}$ und bewirkt damit ein zeitkorrektes Rücksetzen des jeweiligen Filters $F_0$, $F_1$, $F_2$, ..., $F_{N-1}$.

In einer zweiten Ausführungsform der erfindungsgemäßen Filterkaskade mit Reinitialisierung in Fig. 10 wird das Reinitialisierungssignal R einmalig von einer Einheit zur übergeordneten Ablaufsteuerung EAS ausgehend vom abgetasteten Eingangssignal $x_{Dezimationsfilter}(k) = x_{FIR}(k)$ der dezimierenden Filterkaskade verzögerungsfrei erzeugt und dem ersten dezimierenden Filter $F_0$ zum Rücksetzen sämtlicher Verzögerungsstufen zugeführt. Dieses erste dezimie-rende Filter $F_0$ reicht das Reinitialisierungssignal R direkt - nur um die Hardware bedingte Laufzeit verzögert - an das zweite dezimierende Filter $F_1$ zum Rücksetzen von dessen Verzögerungsstufen weiter. Auf diese Weise wird das Reinitialisierungssignal R von jedem vorgelagerten dezimierenden Filter an das jeweils nachfolgende dezimierende Filter weitergereicht, bis es beim letzten dezimierenden Filter $F_{N-1}$ angelangt ist.

Die bisher dargestellte Reinitialisierung der Filterzustände des nicht dezimierenden Filters und des Polyphasendezimators kann alternativ auch auf eine Reinitialisierung einzig der Filterzustände des Polyphasendezimators beschränkt werden. Die Signalwerte am Ausgang der Filter in der Phase des Einschwingvorgangs sind bei einer derartigen Reinitialisierung zwar unterschiedlich zu den Signalwerten am Ausgang der Filter in der Phase des Einschwingvorgangs bei der beschriebenen Reinitialisierung, die Einschwingzeit ist aber in beiden Fällen äquivalent minimal.

Die Erfindung ist nicht auf die dargestellten Ausführungsformen beschränkt. Insbesondere sind außer der in Fig. 6 dargestellten Filterstruktur auch andere Filterstrukturen einer dezimierenden Filterkaskade von der Erfindung abgedeckt. Liegen variabel programmierbare Filterlängen der einzelnen dezimierenden Filter vor, so ist eine frei programmierbare Berechnung der einzelnen Polyphasenkomponenten von der Erfindung ebenfalls abgedeckt.

**Patentansprüche**

1. Filterkaskade mit mindestens einem Filterpfad ($FP_1$; $FP_2$) bestehend aus jeweils mindestens einem dezimierenden Filter ($F_0,F_1,F_2,..,F_\mu,..,F_{N-1}$), wobei der Eingang (E) der Filterkaskade von einem abgetasteten Eingangssignal ($x_0(k_0)$) mit mehreren durch mindestens einen ungültigen Abtastwert voneinander getrennten gültigen Signalabschnitten beaufschlagt wird und wobei jedes dezimierende Filter ($F_0,F_1,F_2,..,F_\mu,..,F_{N-1}$) aus einem nicht dezimierenden Filter (NDF) in Serie zu einem Polyphasendezimator (PPD) besteht,

**dadurch gekennzeichnet,**

**dass** für das dezimierende Filter ($F_\mu$) zwischen den Abtastebenen $\mu$ und $\mu+1$ die Polyphasenkomponente ($P_\mu$) des zugehörigen Polyphasendezimators (PPD) jeweils zu Beginn eines gültigen Signalabschnitts mit einem zu einem Moduluswert ($MOD\{\tilde{L}_{i,\mu}-1-\tilde{p}_{i,\mu},\tilde{R}_{i,\mu+1}\}$) proportionalen Wert reinitialisiert wird, wobei bei der Berechnung des Moduluswertes als Dividend die Differenz zwischen einer um 1 reduzierten Filterlänge ($\tilde{L}i,\mu$) und einer Polyphasenkomponente ($\tilde{p}_{i,\mu}$) eines die zwischen der Abtastebene $i=0$ am Eingang (E) der Filterkaskade und der Abtastebene $\mu$ befindlichen nicht dezimierenden Filter (NDF) und Polyphasendezimatoren (PPD) ersetzenden Ersatzfilters und als Divisor ein Dezimationsfaktor ($\tilde{R}_{i_\mu+1}$) eines die zwischen der Abtastebene $i=0$ am Eingang (E) der Filterkaskade und der Abtastebene $\mu+1$ befindlichen nicht dezimierenden Filter (NDF) und Polyphasendezimatoren (PPD) ersetzenden Ersatzfilters verwendet wird.

2. Filterkaskade nach Anspruch 1,
   **dadurch gekennzeichnet,**
   **dass** die Filterlänge $\tilde{L}_{i,j}$ des Ersatzfilters aus den zwischen dem in der Abtastebene $i$ befindlichen Eingang (E) und einem in der Abtastebene $j$ befindlichen Ausgang ($A_1$;$A_2$) des jeweiligen Filterpfads ($FP_1$;$FP_2$) seriell geschalteten nicht dezimierenden Filtern (NDF) und Polyphasendezimatoren (PPD) aus Filterlängen $L_\mu$ der im jeweiligen Filterpfad ($FP_1$;$FP_2$) jeweils geschalteten nicht dezimierenden Filter (NDF) gemäß folgender Formel bestimmt ist:

$$\tilde{L}_{i,j} = 1 + \sum_{\xi=i}^{j-1}\tilde{R}_{i,\xi}\cdot\left(L_\xi-1\right)$$

wobei $\tilde{R}_{i,\xi}$ der Dezimationsfaktor des Ersatzfilters zwischen den Abtastebenen $i$ und $\xi$ ist,
wobei der Dezimationsfaktor $\tilde{R}_{i,\xi}$ zwischen den Abtastebenen $i$ und $\xi$ gemäß folgender Formel bestimmt ist:

$$\tilde{R}_{i,\xi} = \prod_{\lambda=i}^{\xi-1} R_\lambda \quad \text{mit} \quad \tilde{R}_{i,i} = 1$$

wobei $R_\lambda$ der Dezimationsfaktor eines $\lambda$-ten Polyphasen-filters ab dem Eingang (E) des Filterpfads ($FP_1$;$FP_2$) ist und
wobei $L_\xi$ die Filterlänge eines $\xi$-ten dezimierenden Filters $F_\xi$ ab dem Eingang (E) eines Filterpfads ($FP_1$;$FP_2$) ist.

3. Filterkaskade nach Anspruch 2,
   **dadurch gekennzeichnet,**
   **dass** die Polyphasenkomponente $p_\nu$ des $\nu$-ten Polyphasendezimators eines Filterpfades ($FP_1$; $FP_2$) iterativ aus der Polyphasenkomponente $p_\mu$ aller zwischen der Abtastebene $i=0$ am Eingang (E) des Filterpfads ($FP_1$;$FP_2$) und der Abtastebene $\nu$ befindlichen Polyphasendezimatoren gemäß folgender Formel bestimmt wird:

$$p_\nu = \frac{1}{\displaystyle\prod_{\xi=i}^{\nu-1}R_\xi}\cdot MOD\left\{\tilde{L}_{i,\nu}-1-\sum_{\mu=i}^{\nu-1}\left(\prod_{\xi=i}^{\mu-1}R_\xi\right)\cdot p_\mu,\prod_{\xi=i}^{\nu}R_\xi\right\}$$

wobei $R_\xi$ der Dezimationsfaktor eines $\xi$-ten Polyphasendezimators ab dem Eingang des Filterpfads ($FP_1$;$FP_2$) ist,
wobei $\tilde{L}_{i,\nu}$ die Filterlänge des Ersatzfilters zwischen der Abtastebene $i=0$ und der Abtastebene $\nu$ ist und
wobei $MOD\{\cdot\}$ die Modulo-Funktion ist.

4. Filterkaskade nach einem der Ansprüche 1 bis 3,
   **dadurch gekennzeichnet,**
   **dass** jedes dezimierende Filter ($F_0,F_1,F_2,...,F_{N-1}$) über ein zugehöriges Steuersignal von einer übergeordneten Einheit zur Ablaufsteuerung (EAS) zu Beginn eines neuen gültigen Signalabschnitts reinitialisiert wird.

5. Filterkaskade nach einem der Ansprüche 1 bis 3,
   **dadurch gekennzeichnet,**
   **dass** jedes dezimierende Filter ($F_1, F_2,...,F_{N-1}$) von seinem vorgelagerten dezimierenden Filter ($F_0, F_1, F_2,...,F_{N-2}$) über ein Steuersignal nach dessen Reinitialisierung zu Beginn eines neuen gültigen Signalabschnitts reinitialisiert wird.

6. Filterkaskade nach einem der Ansprüche 1 bis 5,
   **dadurch gekennzeichnet,**
   **dass** nach Reinitialisierung jedes dezimierenden Filters ($F_0, F_1, F_2,...,F_{N-1}$) die Erzeugung des ersten Abtastwertes am jeweiligen Filterausgang ($A_0, A_1, A_2,...,A_{N-1}$) unverzögert erfolgt.

7. Filterkaskade nach einem der Ansprüche 1 bis 6,
   **dadurch gekennzeichnet,**
   **dass** das nicht dezimierende Filter (NDF) ein Finite-Impulse-Response-Filter, ein Infinite-Impulse-Response-Filter oder ein Cascaded-Integrator-Comb-Filter ist.

8. Filterkaskade nach Anspruch 7,
   **dadurch gekennzeichnet,**
   **dass** die Reinitialisierung des jeweiligen dezimierenden Filters ($F_0, F_1, F_2,...,F_{N-1}$) die einzelnen Verzögerungsstufen des Polyphasendezimators und gleichzeitig des Finite-Impulse-Response-Filters, des Infinite-Impulse-Response-Filter oder des Cascaded-Integrator-Comb-Filter zurücksetzt.

9. Filterkaskade nach einem der Ansprüche 1 bis 8,
   **dadurch gekennzeichnet,**
   **dass** die Polyphasenkomponente $p_\nu$ des $\nu$-ten Polyphasendezimators eines Filterpfades ($FP_1; FP_2$) so eingestellt ist, dass der $\nu$-te Polyphasendezimator am Ausgang ($A_\nu$) des $\nu$-ten dezimierenden Filters ($F_\nu$) nach der minimalen Anzahl von Abtastwerten des am Eingang (E) der Filterkaskade anliegenden Eingangssignals ($y_0(k_0)$) einen eingeschwungenen Abtastwert erzeugt.

**Claims**

1. Filter cascade with at least one filter path ($FP_1; FP_2$) consisting of in each case at least one decimating filter ($F_0, F_1, F_2, .., F_\mu, .., F_{N-1}$), wherein the input (E) of the filter cascade is supplied with a sampled input signal ($x_0(k_0)$) with a plurality of valid signal sections separated from one another by at least one invalid sampling value and wherein each decimating filter ($F_0, F_1, F_2, .., F_\mu, .. , F_{N-1}$) is composed of a non-decimating filter (NDF) in series with a polyphase decimator (PPD),
   **characterised in that**
   for the decimating filter ($F_\mu$) between the sampling levels $\mu$ and $\mu+1$ the polyphase component ($P_\mu$) of the associated polyphase decimator (PPD) is in each case reinitialised at the beginning of a valid signal section with a value which is proportional to a modulus value $MOD\{\tilde{L}_{i,\mu}-1-\tilde{p}_{i,\mu}, \tilde{R}_{i,\mu+1}\}$, wherein for the calculation of the modulus value the dividend used is the difference between a filter length ($\tilde{L}_{i,u}$) reduced by 1 and a polyphase component ($\tilde{p}_{i,\mu}$) of a substitute filter replacing the non-decimating filters (NDF) and polyphase decimators (PPD) located between the sampling level $i=0$ at the input (E) of the filter cascade and the sampling level $\mu$ and the divisor used is a decimation factor ($\tilde{R}_{i,\mu+1}$) of a substitute filter replacing the non-decimating filters (NDF) and polyphase decimators (PPD) located between the sampling level $i=0$ at the input (E) of the filter cascade and the sampling level $\mu+1$.

2. Filter cascade according to claim 1,
   **characterised in that**
   the filter length $\tilde{L}_{i,j}$ of the substitute filter is determined from the non-decimating filters (NDF) and polyphase decimators (PPD) connected in series between the input (E) located in the sampling level i and an output (A1; A2) of the respective filter path ($FP_1; FP_2$) located in the sampling level $j$ from filter lengths $L_\mu$ of the non-decimating filters (NDF) connected in each case in the respective filter path ($FP_1; FP_2$) according to the following formula:

$$\tilde{L}_{i,j} = 1 + \sum_{\xi=i}^{j-1} \tilde{R}_{i,\xi} \cdot \left( L_\xi - 1 \right)$$

wherein $\tilde{R}_{i,\xi}$ is the decimation factor of the substitute filter between the sampling levels $i$ and $\xi$,
wherein the decimation factor $\tilde{R}_{i,\xi}$ between the sampling levels $i$ and $\xi$ is determined according to the following formula:

$$\tilde{R}_{i,\xi} = \prod_{\lambda=i}^{\xi-1} R_\lambda \quad \text{in which} \quad \tilde{R}_{i,i} = 1$$

wherein $R_\lambda$ is the decimation factor of a $\lambda$ th polyphase filter from the input (E) of the filter path (FP$_1$; FP$_2$) and wherein $L_\xi$ is the filter length of an $\xi$th decimating filter $F_\xi$ from the input (E) of a filter path (FP$_1$; FP$_2$).

3. Filter cascade according to claim 2,
**characterised in that**
the polyphase component $p_\nu$ of the $\nu$th polyphase decimator of a filter path (FP$_1$; FP$_2$) is determined iteratively from the polyphase component $p_\mu$ of all the polyphase decimators located between the sampling level $i=0$ at the input (E) of the filter path (FP$_1$; FP$_2$) and the sampling level $\nu$ according to the following formula:

$$p_\nu = \frac{1}{\displaystyle\prod_{\xi=i}^{\nu-1} R_\xi} \cdot MOD\left\{ \tilde{L}_{i,\nu} - 1 - \sum_{\mu=i}^{\nu-1} \left( \prod_{\xi=i}^{\mu-1} R_\xi \right) \cdot p_\mu, \prod_{\xi=i}^{\nu} R_\xi \right\}$$

wherein $R_\xi$ is the decimation factor of an $\xi$th polyphase decimator from the input of the filter path (FP$_1$; FP$_2$), wherein $\tilde{L}_{i,\nu}$ is the filter length of the substitute filter between the sampling level $i=0$ and the sampling level $\nu$ and wherein $MOD\{\cdot\}$ is the modulo function.

4. Filter cascade according to one of claims 1 to 3, **characterised in that**
each decimating filter (F$_0$, F$_1$, F$_2$, .., F$\mu$, .., F$_{N-1}$) is reinitialised by means of an associated control signal from a higher level unit for sequential control (EAS) at the beginning of a new valid signal section.

5. Filter cascade according to one of claims 1 to 3, **characterised in that**
each decimating filter (F$_1$, F$_2$, ..., F$_{N-1}$) is reinitialised by its preceding decimating filter (F$_0$, F$_1$, F$_2$, ..., F$_{N-2}$) by means of a control signal after its reinitialisation at the beginning of a new valid signal section.

6. Filter cascade according to one of claims 1 to 5, **characterised in that**
after reinitialisation of each decimating filter (F$_0$, F$_1$, F$_2$, ..., F$_{N-1}$) the generation of the first sampling value at the respective filter output (A$_0$, A$_1$, A$_2$, ..., A$_{N-1}$) takes place without delay.

7. Filter cascade according to one of claims 1 to 6,
**characterised in that**
the non-decimating filter (NDF) is a finite impulse response filter, an infinite impulse response filter or a cascaded integrator comb filter.

8. Filter cascade according to claim 7,
**characterised in that**
the reinitialisation of the respective decimating filter (F$_0$, F$_1$, F$_2$, ..., F$_{N-1}$) resets the individual delay stages of the polyphase decimator and at the same time of the finite impulse response filter, the infinite impulse response filter or the cascaded integrator comb filter.

**9.** Filter cascade according to one of claims 1 to 8,
**characterised in that**
the polyphase component $p_\nu$ of the $\nu$th polyphase decimator of a filter path (FP$_1$; FP$_2$) is set so that the $\nu$th polyphase decimator generates a settled sampling value at the output (A$_\nu$) of the $\nu$th decimating filter (F$_\nu$) after the minimum number of sampling values of the input signal ($x_0$ ($k_0$)) present at the input (E) of the filter cascade.

## Revendications

**1.** Cascade de filtres comportant au moins un trajet de filtre (FP$_1$ ; FP$_2$) constituée respectivement d'au moins un filtre à décimation (F$_0$, F$_1$, F$_2$, ..., F$_\mu$, ..., F$_{N-1}$), dans laquelle l'entrée (E) de la cascade de filtres est alimentée par un signal d'entrée échantillonné ($x_0(k_0)$) comportant plusieurs segments de signaux valides séparés les uns des autres par au moins une valeur d'échantillonnage non valide et dans laquelle chaque filtre à décimation (F$_0$, F$_1$, F$_2$, ..., F$_\mu$, ..., F$_{N-1}$) est constitué d'un filtre à non décimation (NDF) en série jusqu'à un décimateur polyphasé (PPD),
**caractérisée en ce que**
la composante polyphasée (P$\mu$) du décimateur polyphasé associé (PPD) est réinitialisée respectivement au début d'un segment de signal valide avec une valeur proportionnelle à une valeur modulo ($MOD\{\tilde{L}_{i,\mu} - 1 - \tilde{p}_{i,\mu}, \tilde{R}_{i,\mu+1}\}$) pour le filtre à décimation (F$\mu$) entre les plages d'échantillonnage $\mu$ et $\mu+1$, où, lors du calcul de la valeur modulo, la différence entre une longueur de filtre réduite à 1 ($\tilde{L}_{i,\mu}$) et une composante polyphasée ($\tilde{p}_{i,\mu}$) d'un filtre de remplacement remplaçant les filtres à non décimation (NPF) et les décimateurs polyphasés (PPD) se trouvant entre la plage d'échantillonnage i=0 à l'entrée (E) de la cascade de filtres et les plages d'échantillonnage u est utilisée en tant que dividende et un facteur de décimation ($\tilde{R}_{i,\mu+1}$) d'un filtre de remplacement remplaçant les filtres à non décimation (NDF) et les décimateurs polyphasés (PPD) se trouvant entre la plage d'échantillonnage i=0 à l'entrée (E) de la cascade de filtres et la plage d'échantillonnage $\mu+1$ est utilisé en tant que diviseur.

**2.** Cascade de filtres selon la revendication 1, **caractérisée en ce que**
la longueur de filtre ($\tilde{L}_{i,j}$) du filtre de remplacement est déterminée à partir des filtres à non décimation (NDF) et des décimateurs polyphasés (PPD) montés en série entre l'entrée (E) se trouvant dans la plage d'échantillonnage i et une sortie (A$_1$ ; A$_2$) se trouvant dans la plage d'échantillonnage j du trajet de filtre respectif (FP$_1$ ; FP$_2$) à partir des longueurs de filtre L$_\mu$ des filtres à non décimation (NDF) montés respectivement dans le trajet de filtre respectif (FP$_1$ ; FP$_2$) selon la formule suivante :

$$\tilde{L}_{i,j} \;=\; 1 + \sum_{\xi=i}^{j-1} \tilde{R}_{i,\xi} \cdot (L_\xi - 1)$$

où $\tilde{R}_{i,\xi}$ est le facteur de décimation du filtre de remplacement entre les plages d'échantillonnage i et $\xi$,
où le facteur de décimation $\tilde{R}_{i,\xi}$ entre les plages d'échantillonnage i et $\xi$ est déterminé selon la formule suivante :

$$\tilde{R}_{i,\xi} \;=\; \prod_{\lambda=i}^{\xi-1} R_\lambda \quad \text{avec} \quad \tilde{R}_{i,i} = 1$$

où R$_\lambda$ est le facteur de décimation d'un $\lambda$-ième filtre polyphasé à partir de l'entrée (E) du trajet de filtre (FP$_1$ ; FP$_2$) et où L$_\xi$ est la longueur de filtre d'un $\xi$-ième filtre à décimation F$_\xi$ à partir de l'entrée (E) d'un trajet de filtre (FP$_1$ ; FP$_2$).

**3.** Cascade de filtres selon la revendication 2, **caractérisée en ce que**
la composante polyphasée p$_\nu$ du v-ième décimateur polyphasé d'un trajet de filtre (FP$_1$ ; FP$_2$) est déterminée de manière interactive à partir de la composante polyphasée p$_\mu$ de tous les décimateurs polyphasés se trouvant entre la plage d'échantillonnage i=0 à l'entrée (E) du trajet de filtre (FP$_1$ ; FP$_2$) et la plage d'échantillonnage v à partir de la formule suivante :

$$p_\nu = \frac{1}{\prod_{\xi=i}^{\nu-1} R_\xi} \cdot MOD\left\{\tilde{L}_{i,\nu} - 1 - \sum_{\mu=i}^{\nu-1}\left(\prod_{\xi=i}^{\mu-1} R_\xi\right) p_\mu, \prod_{\xi=i}^{\nu} R_\xi\right\}$$

où $R_\xi$ est le facteur de décimation d'un $\xi$-ième décimateur polyphasé à partir de l'entrée du trajet de filtre ($FP_1$ ; $FP_2$),

où $\tilde{L}_{i,\nu}$ est la longueur de filtre du filtre de remplacement entre la plage échantillonnage i=0 et la plage d'échantillonnage $\nu$ et

où MOD{·} est la fonction modulo.

**4.** Cascade de filtres selon l'une des revendications 1 à 3, **caractérisée en ce que**
chaque filtre à décimation ($F_0$, $F_1$, $F_2$, ..., $F_{N-1}$) est réinitialisé par l'intermédiaire d'un signal de commande associé par une unité principale en vue de la commande séquentielle (EAS) au début d'un nouveau segment de signal valide.

**5.** Cascade de filtres selon l'une des revendications 1 à 3, **caractérisée en ce que**
chaque filtre à décimation ($F_0$, $F_1$, $F_2$, ..., $F_{N-1}$) est réinitialisé par son filtre à décimation situé avant ($F_0$, $F_1$, $F_2$, ..., $F_{N-2}$) par l'intermédiaire d'un signal de commande après sa réinitialisation au début d'un nouveau segment de signal valide.

**6.** Cascade de filtres selon l'une des revendications 1 à 5, **caractérisée en ce que**
après la réinitialisation de chaque filtre à décimation ($F_0$, $F_1$, $F_2$, ..., $F_{N-1}$), la génération d'une première valeur d'échantillonnage est effectuée immédiatement à la sortie de filtre respectif ($A_0$, $A_1$, $A_2$, ..., $A_{N-1}$).

**7.** Cascade de filtres selon l'une des revendications 1 à 6, **caractérisée en ce que**
le filtre à non décimation (NDF) est un filtre à réponse impulsionnelle finie, un filtre à réponse impulsionnelle infinie ou un filtre en peigne intégrateur en cascade.

**8.** Cascade de filtres selon la revendication 7, **caractérisée en ce que**
la réinitialisation du filtre à décimation respectif ($F_0$, $F_1$, $F_2$, ..., $F_{N-1}$) réinitialise les différentes étapes de retard du décimateur polyphasé et simultanément du filtre à réponse impulsionnelle finie, du filtre à réponse impulsionnelle infinie ou du filtre en peigne intégrateur en cascade.

**9.** Cascade de filtres selon l'une des revendications 1 à 8, **caractérisée en ce que**
la composante polyphasée $p_\nu$ du $\nu$-ième décimateur polyphasé d'un trajet de filtre ($FP_1$ ; $FP_2$) est déterminée de sorte que le $\nu$-ième décimateur polyphasé génère une valeur d'échantillonnage transitoire à la sortie ($A_\nu$) du $\nu$-ième filtre à décimation ($F_\nu$) après le nombre minimum de valeurs d'échantillonnage du signal d'entrée ($y_0(k_0)$) se trouvant à l'entrée (E) de la cascade de filtres.

## Fig. 1

$$f_{a,in} \qquad\qquad f_{a,out}$$

$$x_{Dezimationsfilter}(k) = x_{FIR}(k)$$

| FIR - Filter: |
| :---: |
| h(k) |
| Filterlänge L |

NDF

$$y_{FIR}(k) = x_{Dezimator}(k)$$

| Dezimator |
| :---: |
| Dezimationsfaktor R |
| Polyphasenkom- |
| ponente p |

PPD

$$y_{Dezimator}(l) = y_{Dezimationsfilter}(l)$$

E

A

## Fig. 4

① ① ② ③ (N-1) (N)

$$x_0(k_0)$$

$$F_0$$

$$h_0(k_0)$$

$$L_0, R_0, p_0$$

E

$$A_0$$

$$y_0(k_1) = x_1(k_1)$$

$$F_1$$

$$h_1(k_1)$$

$$L_1, R_1, p_1$$

$$A_1$$

$$y_1(k_2) = x_2(k_2)$$

$$F_2$$

$$h_2(k_2)$$

$$L_2, R_2, p_2$$

$$A_2$$

$$y_2(k_3) = x_3(k_3)$$

$$\cdots$$

$$F_{N-1}$$

$$h_{N-1}(k_{N-1})$$

$$L_{N-1}, R_{N-1}, p_{N-1}$$

$$A_{N-1}$$

$$y_{N-1}(k_N) = x_N(k_N)$$

$$\tilde{h}_{ij}(k_i), \tilde{L}_{ij}, \tilde{R}_{ij}, \tilde{p}_{ij}$$

EP 1 763 135 B1

# Fig. 2

## (Stand der Technik)

$x_{Dezimator}(k)$

k

$y_{Dezimator}(l) = x_{Dezimator}(Rl+p)$

R=3, p=0

l

$y_{Dezimator}(l) = x_{Dezimator}(Rl+p)$

R=3, p=1

l

$y_{Dezimator}(l) = x_{Dezimator}(Rl+p)$

R=3, p=2

l

# Fig. 3

## Fig. 5

$x_0(k_0)$

$L_0 = 5,$  $R_0 = 3,$  $p_0 = 1$

$y_0(k_1) = x_1(k_1)$

$L_1 = 3,$  $R_1 = 2,$  $p_1 = 1$

$y_1(k_2)$

## Fig. 6

1. Filterpfad FP1

E

$x_0(k)$  $\boxed{h_0, R_0, L_0, p_0}$ $F_0$  $y_0(l_0)$  $A_0$  $x_1(l_0)$  $\boxed{h_1, R_1, L_1, p_1}$ $F_1$  $y_1(l_1)$  $A_1$

$x_2(l_0)$  $\boxed{h_2, R_2, L_2, p_2}$ $F_2$  $y_2(l_2)$  $A_2$

2. Filterpfad FP2

Fig. 7

# Fig. 8

Fig. 9

Fig. 10

EP 1 763 135 B1

# EP 1 763 135 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0285317 A